Europäisches Patentamt

**European Patent Office**

**Office européen des brevets**

(11) Numéro de publication : **0 029 770**
**B1**

(12)                    **FASCICULE DE BREVET EUROPÉEN**

(45) Date de publication du fascicule du brevet :
24.04.85

(21) Numéro de dépôt : **80401609.5**

(22) Date de dépôt : **12.11.80**

(51) Int. Cl.⁴ : **H 03 K 17/96, F 24 C 7/08**

(54) Tableau de commande comportant des touches capacitives à effleurement.

(30) Priorité : **14.11.79 FR 7928101**

(43) Date de publication de la demande :
**03.06.81 Bulletin 81/22**

(45) Mention de la délivrance du brevet :
**24.04.85 Bulletin 85/17**

(84) Etats contractants désignés :
**BE DE GB IT NL**

(56) Documents cités :
**DE-A- 2 318 581**
**DE-A- 2 806 112**
**DE-B- 2 540 423**
**FR-A- 2 374 811**
**GB-A- 1 553 563**

(73) Titulaire : **DE DIETRICH & Cie, Société dite**
**F-67110 Niederbronn-Les-Bains (FR)**

(72) Inventeur : **Gresse, Roland**
**6 Rue des Marguerites Gundershofen**
**F-67110 Niederbronn-Les-Bains (FR)**

(74) Mandataire : **Bressand, Georges et ai**
**c/o CABINET LAVOIX 2 Place d'Estienne d'Orves**
**F-75441 Paris Cedex 09 (FR)**

Jouve, 18, rue St-Denis, 75001 Paris, France

**Description**

La présente invention est relative aux tableaux de commande, claviers et analogues comportant des touches dites « sensitives » ne comportant aucun organe mécanique pour opérer une transition électrique et déclencher la commande, cette transition étant exclusivement obtenue par une perturbation d'une capacité formée par chaque touche. Cette perturbation peut être provoquée par exemple par un effleurement du doigt d'un utilisateur.

Dans le domaine particulier des appareils ménagers (appareils de cuisson, etc.), on a déjà cherché à utiliser des tableaux de commande à touches capacitives afin d'en faciliter l'utilisation. On a donc été conduit à appliquer dans ce domaine particulier, la technique habituelle de réalisation de touches capacitives qui consiste à prévoir de part et d'autre d'une plaque de matière isolante, qui est en général du verre, des électrodes qui avec ce verre comme diélectrique forment ensemble deux condensateurs en série, et dont le point de jonction constitue une armature commune que l'utilisateur doit toucher pour provoquer un changement de capacité de l'ensemble.

Les armatures étant formées par de minces feuilles de métal, il faut pour assurer la rigidité nécessaire d'un tel tableau de commande, choisir une plaque isolante d'une épaisseur suffisante. Cependant, comme la capacité d'un condensateur varie en raison inverse avec l'épaisseur de son diélectrique, de telles plaques conduisent à des valeurs de capacité relativement faibles que l'on ne peut augmenter qu'en augmentant la surface des armatures, toutes choses égales par ailleurs. Il en résulte alors une faible densité de touches par unité de surface du tableau de commande, ce qui est gênant pour des raisons d'encombrement notamment. Naturellement, cet inconvénient peut également être trouvé dans d'autres applications telles que les claviers de machines à calculer, à écrire, etc.

En ce qui concerne les appareils ménagers, les tableaux de commande sont, en général, réalisés sur une partie de la tôlerie enveloppant l'appareil, la tôle étant le plus souvent émaillée. Du point de vue électrique, la tôle empêche de constituer sur une telle plaque un condensateur comme on a l'habitude de le faire sur les plaques en verre, c'est-à-dire, en prévoyant des armatures de part et d'autre de la plaque.

Le DE-B-2 540 423 (MERTEN) décrit une touche à effleurement pouvant déclencher un signal de commande grâce à la perturbation capacitive provoquée par l'approche du doigt d'un utilisateur, cette touche comportant deux électrodes réunies par une couche isolante qui forme le côté accessible de la touche, ainsi qu'un support rigide comportant à la face opposée aux électrodes un écran constituant un plan équipotentiel pour la suppression des capacités parasites.

Ce dispositif connu constitue un dispositif d'actionnement autonome, par exemple, un interrupteur du type que l'on utilise habituellement dans les habitations pour installations électriques. A partir d'un certain nombre de dispositifs autonomes de ce type on pourrait constituer un tableau de commande destiné à un appareil ménager par exemple, mais cette solution conduirait à un ensemble compliqué et encombrant peu compatible avec ce genre d'applications.

On a vu par ailleurs, qu'un appareil ménager comporte en général un habillage en tôle émaillée, qui est isolante du point de vue électrique.

L'invention vise à mettre à profit la présence d'une tôle émaillée pour constituer un tableau de commande pourvu de touches à effleurement du type connu défini ci-dessus.

Elle a donc pour objet un tableau de commande, clavier ou analogue, notamment pour appareil ménager comportant plusieurs touches à effleurement, chacune de ces touches pouvant déclencher un signal de commande grâce à la perturbation capacitive provoquée par l'approche du doigt d'un utilisateur, et chaque touche comportant au moins deux électrodes réunies par une couche isolante qui forme le côté accessible de la touche ainsi qu'un support rigide comportant à la face opposée aux électrodes un écran constituant un plan équipotentiel pour la suppression des capacités parasites, caractérisé en ce que l'ensemble de ladite couche isolante et lesdites électrodes est déposé sur une tôle émaillée qui constitue à la fois ledit support conférant au tableau la rigidité nécessaire et ledit écran pour la suppression des capacités parasites.

La description qui va suivre, est donnée uniquement à titre d'exemple et est faite en se référant aux dessins annexés, sur lesquels :

La Figure 1 est une vue en perspective schématique d'une touche pour tableau de commande réalisée selon un premier mode de réalisation de l'invention ;

La Figure 2 représente à plus grande échelle, un second mode de réalisation d'une touche ;

la Figure 3 est une vue en perspective éclatée d'un tableau de commande comportant des touches suivant l'invention ;

les Figures 4 à 7 représentent des vues en coupe transversale d'autres modes de réalisation de l'invention.

La description qui va suivre concerne plus particulièrement des touches et des ensembles de touches destinés à être utilisés dans des appareils ménagers dont la structure comporte des tôles émaillées, cette application étant d'ailleurs représentée aux Figures.

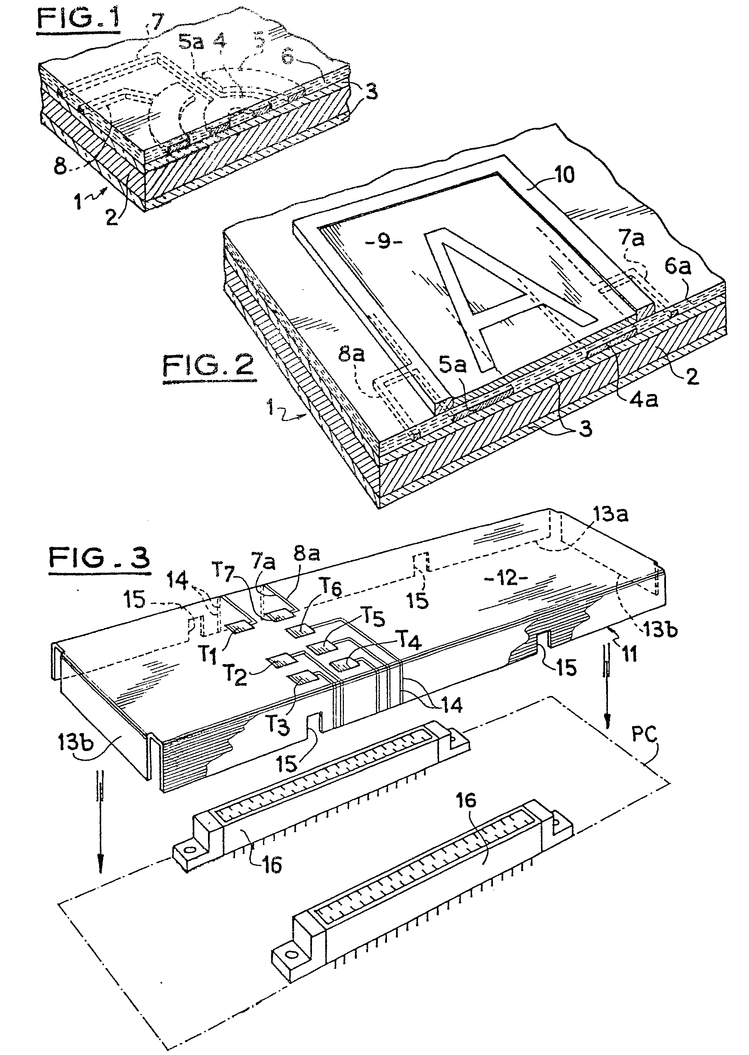

En se référant tout d'abord à la Fig. 1, on voit que dans sa forme la plus simple, la touche d'un tableau suivant l'invention comporte un support 1 qui est ici une tôle revêtue sur ces deux faces d'une couche isolante d'émail 3. Ce support constitue l'élément donnant la rigidité mécanique nécessaire à la touche. Dans toutes les variantes décrites ci-dessus, le support est plan ce qui donne à la touche également une forme plane. Toutefois, le support et/ou la touche peuvent présenter localement ou en totalité une forme convexe ou concave, sans que l'on sorte du cadre de l'invention.

La face tournée vers l'extérieur (ici la face supérieure) du support 1 de la touche comporte deux armatures 4 et 5 qui sont, à titre d'exemple, de forme annulaire et concentrique. Ces armatures sont réalisées de préférence par un dépôt de métal exécuté à l'aide des techniques de sérigraphie, des encres conductrices à base d'argent pouvant convenir à cet effet.

Les deux armatures 4 et 5 sont recouvertes d'une couche de diélectriques 6 de préférence réalisée à base d'une peinture ou laque isolante de coefficient diélectrique approprié.

Chaque armature comporte un conducteur électrique 7 ou 8 obtenu en même temps que l'armature et destiné à la connexion avec un circuit électronique d'exploitation de type connu (non représenté).

Dans cette forme la plus simple, la touche suivant l'invention ne comporte que deux armatures qui du point de vue électrique constituent deux condensateurs en série lorsqu'un doigt est placé sur la zone dans laquelle se trouve l'ensemble. L'effleurement peut ainsi modifier capacitivement le couplage entre les armatures 4 et 5 et opérer le transfert d'une impulsion par exemple engendrée puis détectée, le cas échéant, par le circuit électronique.

Il est à noter que l'armature 5 ne constitue pas un anneau complet, l'interstice 5a étant destiné au passage du conducteur 7 de l'autre armature.

Bien entendu, la configuration décrite des armatures 4 et 5 n'est choisie qu'à titre d'exemple, toute autre forme, telle que des symboles ou analogues pouvant être donnée aux armatures. D'ailleurs, la forme de la touche pouvant être également bombée ou concave, il est possible de lui conférer également un code à l'aide de cette forme. Un tel agencement pourrait être utilisé notamment dans des tableaux de commande destinés aux personnes dont la vue est déficiente.

On notera que selon l'invention le support 1 est constitué par une tôle émaillée, comme cela est représenté sur les figures, le métal de ce support constitue un plan équipotentiel permettant de limiter l'influence des capacités parasites sur la touche. Ce plan est de préférence un plan de masse.

La Fig. 2 représente une autre forme de réalisation de l'invention, dans laquelle le support 1 composé d'une tôle 2 et de couches d'émail 3 porte deux zones conductrices 4a et 5a espacées et connectées respectivement à des conducteurs 7a et 8a destinés à relier les zones 4a et 5a à un circuit extérieur. Les zones ou armatures sont recouvertes d'une couche 6a d'un matériau diélectrique à son tour partiellement recouverte d'une couche conductrice 9 qui s'étend au-dessus des armatures 4a et 5a et qui peut être obtenue de la même façon que les armatures 4a et 5a ou 4 et 5 (Fig. 1). L'armature 9 est électriquement l'électrode commune de deux condensateurs (4a, 9 - 5a, 9) connectés en série et qui, lorsqu'un doigt vient effleurer l'armature 9 sont reliés capacitivement à la masse par leur jonction commune. Dans cet exemple également, l'armature 9 peut revêtir toute forme voulue, être elle-même un symbole ou représenter une lettre ou un chiffre, par exemple. L'armature 9 peut être bordée d'un cadre 10 en une matière isolante ou conductrice. Ici également, et dans les Fig. suivantes, on notera le rôle de réduction des capacités parasites de la tôle 2.

La Fig. 3 représente schématiquement une vue éclatée d'un tableau de commande 11 équipé de touches, selon l'invention. Le support des touches T1 à T7 est ici le châssis du tableau et est constitué d'une tôle émaillée en forme de panneau 12 avec les rebords repliés 13a et 13b sur les quatre côtés. les touches T1 à T7 sont réalisées conformément à la Fig. 2 et regroupées selon une configuration choisie en fonction des commandes qu'elles doivent déclencher dans un appareil équipé du tableau. Chaque touche est reliée à deux conducteurs 7a et 8a qui s'étendent d'abord vers les bords du panneau 12 et traversent ensuite la surface extérieure des grands rebords 13a par des portions à découvert 14. Ceci signifie que dans la région du panneau 12, les conducteurs 7a et 8a sont recouverts de la couche diélectrique 6a ou d'une couche de décor, commune à toutes les touches T1 à T7, tandis que cette couche manque tout au moins dans les zones de rebords 13 où se trouvent les prolongements 14 des conducteurs.

Dans l'exemple représenté, les grands rebords 13a présentent chacun deux encoches 15 auxquelles s'adaptent les extrémités de deux fiches 16 du type normalisé et montées sur une plaquette de circuit imprimé PC portant les circuits électroniques d'exploitation des données de commande fournies par les touches T1 à T7. les fiches 16 peuvent ainsi être engagées sur les grands rebords 13a du tableau 11 pour en assurer la connexion électrique et la fixation mécanique.

Bien entendu, ni la forme du tableau, ni le groupement des touches ne sont limitatifs, le tableau de la Fig. 3 n'étant choisi qu'à titre d'exemple. C'est ainsi, que selon une variante (non représentée), on peut concevoir un tableau de forme circulaire comportant un rebord présentant les extrémités des conducteurs tels que 7a et 8a à une fiche de connexion suivant tout ou partie de la périphérie du tableau circulaire.

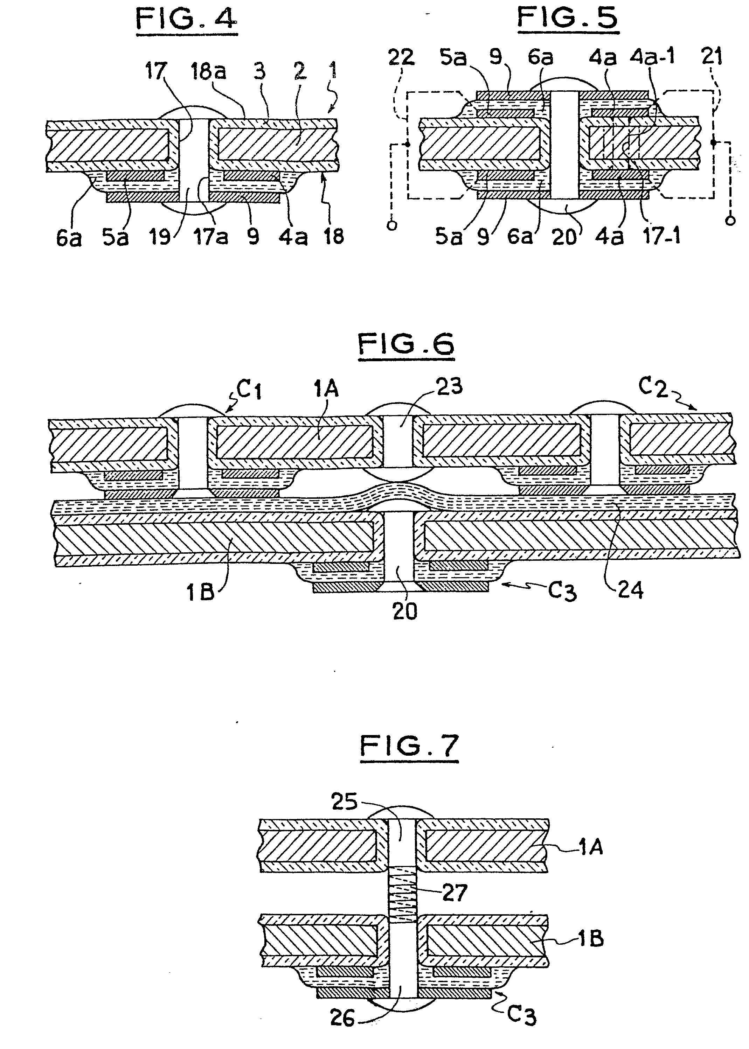

La Fig. 4 montre une vue en coupe transversale d'une autre variante de l'invention. Dans ce cas, le support (tôle émaillée) comporte un perçage 17 à l'endroit de chaque touche de commande.

Sur la face non accessible 18 de ce support, sont déposées successivement les armatures 4a et 5a, la couche de diélectrique 6a et l'armature 9, le perçage 17 étant prolongé en 17a dans cette superposition de couches. Un rivet 19 traverse l'ensemble pour assurer une connexion électrique entre l'armature commune 9 et la face extérieure accessible 18a du tableau de commande. Bien entendu, la paroi intérieure du perçage 17 est garnie d'émail pour assurer l'isolation entre la tôle centrale 2 et le rivet 19. Cette variante présente l'avantage que les parties fragiles de la touche se trouvent sur la face intérieure du tableau, les protégeant ainsi contre les chocs, par exemple, ce qui peut être souhaitable dans le cas des appareils ménagers notamment.

La variante de la Fig. 5 vise à doubler la capacité de la touche. Ici, l'agencement est dans son principe identique à celui de la Fig. 4, des condensateurs étant cependant formés sur les deux faces du support 1, les armatures extérieures 9 étant connectées électriquement ensemble par un rivet 20 traversant l'ensemble. Bien entendu, dans ce cas, les armatures équivalentes sont reliées en parallèle. Ainsi, les armatures 4a sont reliées ensemble à un conducteur 21, tandis que les armatures 5a sont connectées ensemble à un conducteur 22, les deux armatures extérieures 9 étant raccordées par le rivet 20. Il est possible de remplacer les conducteurs 21 et 22 reliant les armatures équivalentes l'une à l'autre par ces connexions intérieures. Sur la Fig. 5, on a représenté en traits mixtes, une telle connexion qui peut être formée par exemple par l'encre 4a-1 de la couche conductrice 4a ou 5a traversant un trou 17-1 entièrement émaillé de la tôle 1.

Le mode de réalisation de la Fig. 6, a pour but d'augmenter davantage la densité des touches par unité de surface du tableau de commande. L'agencement représenté comporte deux supports superposés 1A et 1B en tôle émaillée et pourvus chacun de plusieurs jeux de condensateurs C1, C2, C3, etc. du type représenté à la Fig. 4. Les condensateurs associés au support sous-jacent 1B, tels que le condensateur C3, sont reliés à des rivets 23 traversant le support supérieur 1A au droit du condensateur respectif. Une couche 24 formée d'un matelas élastique à conduction transversale est placée entre les deux supports 1A et 1B et cette couche ayant la propriété de ne conduire transversalement que dans des zones où elle est comprimée, il s'établit une connexion électrique entre les rivets 23 et le rivet 20 du condensateur C3, la distance entre leurs extrémités étant calculée spécialement dans ce but.

La Fig. 7 montre une variante de connexion entre un condensateur sous-jacent C3 et un élément conducteur supérieur 25 qui présente ici la forme d'un clou, tandis que le condensateur C3 présente un élément de connexion 26 ayant la forme d'une broche. Les éléments 25 et 26 sont connectés électriquement ensemble par un ressort 27.

Il est à noter que sur toutes les figures, les épaisseurs tant des armatures que de la couche diélectrique ont été exagérées pour la clarté du dessin. On peut noter par ailleurs, que les encres conductrices et les laques diélectriques peuvent avantageusement être celles commercialisées par la Société Dupont de Nemours.

## Revendications

1. Tableau de commande, clavier ou analogue, notamment pour appareil ménager comportant plusieurs touches à effleurement (1, T1 à T6) chacune de ces touches pouvant déclencher un signal de commande grâce à la perturbation capacitive provoquée par l'approche du doigt d'un utilisateur, et chaque touche comportant au moins deux électrodes (4, 5 ; 4a, 9, 5a, 9) réunies par une couche isolante (6, 6A) qui forme le côté accessible de la touche ainsi qu'un support rigide (2, 3) comportant à la face opposée aux électrodes un écran (2) constituant un plan équipotentiel pour la suppression des capacités parasites, caractérisé en ce que l'ensemble de ladite couche isolante (6, 6a) et lesdites électrodes (4, 5 ; 4a, 9, 5a, 9) est déposé sur une tôle émaillée (2, 3) qui constitue à la fois ledit support conférant au tableau la rigidité nécessaire et ledit écran pour la suppression des capacités parasites.

2. Tableau suivant la revendication 1, caractérisé en ce qu'au moins certaines desdites électrodes sont pourvues de conducteurs (7a, 8a) pour l'établissement de connexions avec un circuit d'exploitation (PC), lesdits conducteurs étant à découvert sur au moins un bord dudit support, ce bord étant adapté pour coopérer avec une fiche normalisée (16) de connexion.

3. Tableau suivant la revendication 2, caractérisé en ce que ledit support comporte à ses quatre côtés des rebords repliés à 90° vers sa face arrière et en ce que des fiches de connexion (16) sont adaptables sur deux rebords opposés (13a) ainsi repliés, lesdites fiches étant montées sur une carte de circuit imprimé (CE) avec laquelle ledit support peut être solidarisé par l'intermédiaire des fiches (16).

4. Tableau suivant l'une quelconque des revendications précédentes, caractérisé en ce que chaque touche comporte deux électrodes (4, 5) adjacentes noyées dans ladite couche isolante (6).

5. Tableau suivant l'une quelconque des revendications 1 à 4, caractérisé en ce que chaque touche comprend deux électrodes (4a, 5a) adjacentes noyées dans ladite couche isolante (6a) qui les recouvre également, une région conductrice (9) étant déposée sur ladite couche isolante en recouvrant lesdites électrodes, l'agencement formant ainsi un jeu de deux condensateurs en série, dont l'armature commune est destinée à être effleurée par le doigt d'un utilisateur.

6. Tableau suivant la revendication 5, caractérisé en ce que ledit jeu de deux condensateurs est prévu sur la face cachée du support (3) et en ce qu'un élément conducteur (19) en contact avec ladite région conductrice commune (9) est placé dans un trou (17, 17a) traversant le jeu de condensateurs et ledit support (1) de façon à pouvoir être effleuré à son extrémité débouchant à la face apparente du support (Figure 4).

7. Tableau suivant la revendication 6, caractérisé en ce qu'il comporte au moins deux supports parallèles (1A, 1B) portant chacun un réseau de jeux de touches (T1 à T7), et en ce que les jeux de condensateurs (C3) formés par les électrodes correspondantes et portés par le support (1B) placé dans une position non apparente sont connectés respectivement à travers au moins un élément de connexion (24 ; 27) qui est en contact avec ladite région conductrice (9), à des organes d'effleurement (23 ; 25) traversant le support (1A) se trouvant du côté apparent du tableau, pour pouvoir être effleuré avec le doigt.

8. Tableau suivant la revendication 7, caractérisé en ce que ledit élément de connexion est un matelas (24) à conduction transversale par pression, qui est comprimé pour établir localement une connexion au-dessus dudit jeu de condensateurs (C3) du support non apparent (1B), par l'intermédiaire dudit organe d'effleurement (23).

9. Tableau suivant la revendication 7, caractérisé en ce que ledit élément de connexion est un ressort (27) placé entre ledit jeu de condensateurs (C3) du support non apparent (1B) et ledit organe d'effleurement (25).

10. Tableau suivant la revendication 5, caractérisé en ce qu'un jeu de condensateurs est prévu sur les deux faces du support et en ce que les régions conductrices communes (4a, 9) des deux jeux sont connectées ensemble par un élément conducteur (17-1, 20) placé dans un trou (17, 17-1) traversant ledit support (1).

## Claims

1. Control panel, keyboard or the like, in particular for a household apparatus comprising a plurality of touch-sensitive keys (1, T1 to T6), each of these keys being capable of initiating a control signal by means of the capacitive disturbance produced by the approach of the finger of a user, and each key comprising at least two electrodes (4, 5 ; 4a, 9, 5a, 9) interconnected by an insulating layer (6, 6A) which forms the accessible side of the key, and a rigid support (2, 3) comprising on the side opposed to the electrodes a screen (2) constituting an equipotential plane for the suppression of parasitic capacities, characterised in that the whole of said insulating layer (6, 6A) and said electrodes (4, 5 ; 4a, 9, 5a, 9) is deposited on an enamelled metal sheet (2, 3) which constitutes both said support imparting the required stiffness to the panel and said screen for suppressing the parasitic capacities.

2. A panel according to claim 1, characterised in that at least certain of said electrodes are provided with conductors (7a, 8a) for establishing connections with a utilization circuit (PC), said conductors being bare on at least an edge of said support, said edge being adapted to cooperate with a standardized connecting plug (16).

3. A panel according to claim 2, characterized in that said support comprises on its four sides flanges bent at 90° toward its rear face and connecting plugs (16) are adaptable to two opposed flanges (13a) which are bent in this way, said plug being mounted on a printed circuit board (CE) with which said supports may be connected by means of the plugs (16).

4. A panel according to any one of the preceding claims, characterised in that each key comprises two adjacent electrodes (4, 5) embedded in said insulating layer (6).

5. A panel according to any one of the claims 1 to 4, characterised in that each key comprises two adjacent electrodes (4a, 5a) which are embedded in said insulating layer (6a) which also covers them, a conductive region (9) being deposited on said insulating layer and covering said electrodes, the arrangement thus forming a set of two capacitors connected in series, the common armature of which is adapted to be touched by the finger of a user.

6. A panel according to claim 5, characterised in that said set of two capacitors is provided on the hidden face of the support (3) and a conductive element (19) in contact with said common conductive region (9) is placed in an aperture (17, 17a) which extends through the set of capacitors and said support (1) so as to be touched at its end which is adjacent to the visible face of the support (Fig. 4).

7. A panel according to claim 6, characterised in that it comprises at least two parallel supports (1A, 1B) each of which carries a network of sets of keys (T1 to T7), and the sets of capacitors (C3) formed by the corresponding electrodes and carried by the support (1B) placed in a non-visible position are respectively connected through at least one connection element (24 ; 27) which is in contact with said conductive region (9), to touch-sensitive means (23 ; 25) extending through the support (1A) located on the visible side of the panel so as to be touched with the finger.

8. A panel according to claim 7, characterised in that said connecting element is a pad providing a transverse conduction by pressure, which is compressed so as to locally establish a connection above said set of capacitors (C3) of the non-visible support (1B), through said touch-sensitive means (23).

9. A panel according to claim 7, characterised in that said connecting element is a spring (27) placed between said set of capacitors (C3) of the non-visible support (1B) and said touch-sensitive means (25).

10. A panel according to claim 5, characterised in that a set of capacitors is provided on the two faces of the support and the common conductive regions (4a, 9) of the two sets are connected together by a conductive element (17-1, 20) placed in an aperture (17, 17-1) which extends through said support (1).

## Patentansprüche

1. Steuerfeld, Tastenfeld oder ähnliches, insbesondere für eine Küchenmaschine, die eine Anzahl von Berührungstasten (1, T1 bis T6) aufweist, von denen jede ein Steuersignal aufgrund einer kapazitiven Störung auslösen kann, die durch Annäherung des Fingers eines Benutzers hervorgerufen wird und wobei jede Taste mindestens zwei Elektroden (4, 5 ; 4a, 9, 5a, 9) aufweist, die durch eine Isolierschicht (6, 6A) verbunden sind, welche die Zugriffsseite für die Taste sowie einen festen Träger (2, 3) bildet, der auf der gegenüberliegenden Seite der Elektroden eine Abschirmung aufweist, die eine Äquipotentialfläche zur Unterdrückung von Streukapazitäten bildet, dadurch gekennzeichnet, daß die Gesamtheit der besagten Isolierschicht (6, 8a) und der Elektroden (4, 5 ; 4a, 9, 5a, 9) auf einem Emailleblech (2, 3) angeordnet ist, das gleichzeitig den erwähnten Träger, der dem Feld die notwendige Starrheit verleiht, und die Abschirmung für die Unterdrückung der Streukapazitäten bildet.

2. Feld nach Anspruch 1, dadurch gekennzeichnet, daß mindestens gewisse Elektroden mit Leitern (7a, 8a) zur Errichtung von Verbindungen mit einer Auswerteschaltung (PC) vorgesehen sind, wobei die Leiter auf mindestens einem Rand des Trägers freiliegen und dieser Rand zum Zusammenwirken mit einem normierten Verbindungsstecker (16) gestaltet ist.

3. Feld nach Anspruch 2, dadurch gekennzeichnet, daß der Träger an seinen vier Rändern Wülste aufweist, die um 90° gegen die Rückseite umgefaltet sind, und daß Verbindungsstecker (16) an zwei gegenüberliegende, auf diese Art umgefaltete Wülste (13a) angepaßt sind, wobei die Stecker auf einer Leiterplatte (CE) angebracht sind, mit der der Träger mittels der Stecker (16) verbunden werden kann.

4. Feld nach einem der vorhergehenden Ansprüche, dadurch gekennzeichnet, daß jede Taste zwei benachbarte Elektroden (4, 5) aufweist, die in die Isolierschicht (6) eingebettet sind.

5. Feld nach einem der Ansprüche 1 bis 4, dadurch gekennzeichnet, daß jede Taste zwei benachbarte Elektroden (4a, 5a), die in die Isolierschicht (6a), die sie ebenfalls abdeckt, eingebettet sind, und einen leitfähigen Bereich (9) aufweist, der auf der Isolierschicht der Elektroden abdeckend aufgebracht ist, wobei diese Vorrichtung auf diese Art eine Gruppe von zwei in Reihe geschalteten Kondensatoren bildet, deren gemeinsame Formstruktur dazu bestimmt ist, vom Finger einer Bedienungsperson streifend berührt zu werden.

6. Feld nach Anspruch 5, dadurch gekennzeichnet, daß die Gruppe der zwei Kondensatoren auf der Seite vorgesehen ist, die von dem Träger (3) überdeckt ist, und daß ein Leiterelement (19), das im Kontakt mit dem gemeinsamen Leitfähigkeitsbereich (9) ist, in einer Ausnehmung (17, 17a) verlegt ist, welche die Gruppe der Kondensatoren und den Träger (1) in einer Weise durchsetzt, daß er an seinem ausmündenden Ende an der sichtbaren Fläche des Trägers gestreift werden kann (Figur 4).

7. Feld nach Anspruch 6, dadurch gekennzeichnet, daß es mindestens zwei parallele Träger (1A, 1B) aufweist, von denen jeder ein Netz von Tastengruppen (T1 bis T7) trägt, und daß die Gruppen von Kondensatoren (C3), die durch die entsprechenden Elektroden gebildet und von dem Träger (1B) getragen werden, wobei der Träger in einer nicht sichtbaren Lage angeordnet ist, gegenseitig mit wenigstens einem Verbindungselement (24 ; 27), das mit dem Leiterbereich (9) für die Berührungsorgane (23 ; 25) in Verbindung steht, das den Träger (1A) durchquert und sich an der sichtbaren Seite des Feldes befindet, querverbunden ist, um mit dem Finger berührt zu werden.

8. Feld nach Anspruch 7, dadurch gekennzeichnet, daß das Verbindungselement eine Matte (24) zur transversalen Leitung durch Druck ist, die komprimiert wird, um lokal über der Gruppe der Kondensatoren (C3) eine Verbindungen zur nicht sichtbaren Seite des Trägers (1B) mittels des Berührungsorgans (23) herzustellen.

9. Feld nach Anspruch 7, dadurch gekennzeichnet, daß das Verbindungselement eine Feder (27) ist, die zwischen der Gruppe der Kondensatoren (C3) des nicht sichtbaren Trägers (1B) und des Berührungsorgans (25) angebracht ist.

10. Feld nach Anspruch 5, dadurch gekennzeichnet, daß eine Gruppe von Kondensatoren auf zwei Seiten des Trägers vorgesehen ist, und daß die gemeinsamen Leiterbereiche (4a, 9) der zwei Gruppen durch ein Leiterelement (17-1, 20) miteinander verbunden sind, das in einer Ausnehmung (17, 17-1) angeordnet ist, welche den Träger (1) durchquert.

FIG.1

FIG.2

FIG.3

0 029 770

FIG.4

FIG.5

FIG.6

FIG.7